Europäisches Patentamt

European Patent Office

Office européen des brevets

(19)

(11) Veröffentlichungsnummer: **0 019 154**
**A1**

(12) **EUROPÄISCHE PATENTANMELDUNG**

(21) Anmeldenummer: **80102371.4**

(22) Anmeldetag: **02.05.80**

(51) Int. Cl.³: **G 01 N 27/22**

(30) Priorität: **11.05.79 DE 2919230**

(43) Veröffentlichungstag der Anmeldung:
**26.11.80 Patentblatt 80/24**

(84) Benannte Vertragsstaaten:
**AT BE CH DE FR GB IT LI LU NL SE**

(71) Anmelder: **BASF Aktiengesellschaft**
**Carl-Bosch-Strasse 38**
**D-6700 Ludwigshafen(DE)**

(72) Erfinder: **Raab, Helmut, Dr.**
**Theodor-Heuss-Strasse 8**
**D-6940 Weinheim(DE)**

(72) Erfinder: **May, Klaus**
**Berliner Strasse 17**
**D-6701 Waldsee(DE)**

(54) **Messverfahren und Messschaltung zur kontinuierlichen Feuchtemessung.**

(57) Meßverfahren und Meßschaltung zur kontinuierlichen meßtechnischen Erfassung von Feuchte mittels eines kapazitiven Feuchtefühlers (4), der als Kapazität eines Oszillators (1) geschaltet ist, dessen Frequenz durch Zählen der Schwingungen direkt digital ausgewertet und das Zahlergebnis direkt oder nach Umrechnung in die Feuchte-einheit angezeigt wird.

FIG.2

EP 0 019 154 A1

Meßverfahren und Meßschaltung zur kontinuierlichen
Feuchtemessung

Die Erfindung betrifft ein Meßverfahren zur kontinuierlichen meßtechnischen Erfassung von Feuchte mittels eines kapazitiven Feuchtefühlers, bei dem die Frequenz eines Oszillators durch die Kapazität des Feuchtefühlers beeinflußt wird und die beeinflußte Frequenz als Meßsignal in einer Auswerteschaltung verarbeitet und danach zur Anzeige gebracht wird. Ferner betrifft die Erfindung eine Meßschaltung zur Durchführung des Meßverfahrens mit einem kapazitiven Feuchtefühlers, der als Kapazität eines Oszillators geschaltet ist.

In der Feuchtemeßtechnik ist es bekannt, zur Messung der Feuchte in Gasen, Flüssigkeiten oder Feststoffen kapazitive Feuchtefühler zu verwenden. Man ist dabei bestrebt, die gemessene Feuchte linear und digital anzuzeigen, um so eine schnelle, direkt verständliche Information über den Feuchtegehalt in einem ablaufenden Prozeß, z.B. einer Trocknung, zu liefern. Feuchteanalysatoren, die diesen Anforderungen genügen, bestehen neben dem Feuchtefühler aus einem Analogteil, in dem die Verarbeitung des Meßsignals erfolgt, und einem Digitalteil, meistens für die Linearisierung und Ansteuerung der Digitalanzeige.

Eine bekannte Signalverarbeitung gemäß eines Firmenprospekts der Firma Endress und Hauser, 7867 Maulburg, nutzt die Abhängigkeit des Wechselstromwiderstandes eines kapazitiven Feuchtefühlers von der Feuchte aus. Zu diesem Zweck wird der Fühler mit einer Wechselspannung fester Frequenz betrieben, die einen dem Leitwert proportionalen

Sp/BL

Strom durch den Fühler bewirkt. Dieser Strom wiederum wird in eine Wechselspannung umgewandelt und gleichgerichtet, um damit das eigentliche Meßsignal zu erhalten. Andere bekannte Brückenmeßschaltungen zur Erfassung der Kapazitätsänderung von Feuchtefühlern erzeugen gleichfalls als Meßsignal eine Gleichspannung, deren Größe von der gemessenen Feuchte abhängt.

Ein analoges Meßsignal, welches digital weiterverarbeitet werden soll, muß zuerst in ein Digitalsignal umgesetzt werden, was zusätzlichen Aufwand erfordert. Außerdem ist eine analoge Signalverarbeitung, sofern keine Gegenmaßnahmen ergriffen werden, von Temperatureinflüssen und Spannungsschwankungen abhängig. Ferner ist von Nachteil, daß der Abgleich von Analogschaltungen zeitaufwendig ist, defekte Bauteile oft nur schwierig erkannt werden können und die Variabilität und Anpassung an neue zunächst nicht bekannte Meßaufgaben schwierig ist, häufig dann verbunden mit Schaltungsänderungen. Die Übertragung von Analogsignalen über größere Entfernungen, wie sie bei der räumlichen Trennung von Feuchtefühler und Signalverarbeitung vorkommt, ist störanfällig und kann den eigentlichen Meßwert beeinflußen, so daß die Meßleitung mit eingeeicht werden muß.

Der Erfindung liegt die Aufgabe zugrunde, ein Meßverfahren und eine Meßschaltung zu entwickeln, die bei Verwendung von kapazitiven Feuchtefühlerm ohne Analog/Digital-Umwandlung eine möglichst einfache digitale Auswertung der Meßwerte ermöglichen. Dabei sollen die beiden herkömmlichen analogen Signalverarbeitungen möglichen Störgrößen vermieden werden. Ferner sollen die Meßwertauswertung und -verarbeitung flexibel sein und einen großen dynamischen Meßbereich zulassen. Darüberhinaus wird gefordert, daß die Übertragung des Meßsignals auch

0019154

über große Strecken unter Berücksichtigung der örtlich möglichen Störgrößen fehlerfrei ist.

Die Aufgabe wurde durch ein Meßverfahren der eingangs beschriebenen Art gelöst, indem die durch den Feuchtefühler beeinflußte Frequenz durch Zählen der Schwingungen des Oszillatorsignals in einem vorgegebenen Zeitintervall direkt digital ausgewertet und das Zählergebnis direkt oder nach Umrechnung in die Feuchteeinheit angezeigt wird. Die Meßschaltung ist zur Lösung der Aufgabe dadurch gekennzeichnet, daß der Ausgang des Oszillatos über eine digitale Auswerteschaltung mit einer Anzeigeeinrichtung in Verbindung steht.

Im Gegensatz zu den bekannten kapazitiven Feuchtemessungen ist bei dem erfindungsgemäßen Meßverfahren der Feuchtegehalt proportional einer Frequenz. Die Weiterverarbeitung einer Frequenz kann direkt digital erfolgen.

Alle Nachteile von analogen Verstärkern oder analogen Verknüpfungen werden damit vermieden, da nur noch der Oszillator analog aufgebaut ist. Digital arbeitende Linearisierungen und Digitalanzeigen sind keine separaten Einheiten des Meßumformers mehr, sondern in der digitalen Meßwertverarbeitung integriert. Durch Verändern der Grundfrequenz des Oszillators unter Beachtung gewisser Randbedingungen, wie z.B. der Schnelligkeit der nachgeschalteten Bauteile, ist es möglich, auch außerordentlich kleine feuchtebedingte Kapazitätsänderungen mit großer Genauigkeit zu erfassen. Hieraus folgt ein großer dynamischer Bereich für die Feuchtemessung.

Besonders vorteilhaft ist die Frequenzerzeugung direkt am Ort des kapazitiven Feuchtefühlers. Damit bilden Feuchtefühler und Oszillator eine Einheit, was nicht zuletzt die

0019154

Handhabung und Installation einer Feuchtemessung nach diesem Verfahren erleichtert. Vorteilhaft anzusehen ist ferner, daß als Meßwert nur Frequenzen übertragen werden. Vor allem bei räumlicher Trennung von Feuchtefühler und Signalverarbeitung gewinnt man hiermit eine erhebliche Störsicherheit.

Durch Verwendung eines Mikroprozessors ergeben sich noch weitere vorteilhafte Eigenschaften des Meßverfahrens und der Meßschaltung:

- Linearisierung und Umrechnung der Meßwerte in beliebige Einheiten
- Wahl des günstigsten Meßbereichs
- Anzeige von Statussignalen zur Eigenüberwachung und von Grenzwerten
- Korrigierbarkeit von Veränderungen des Feuchtefühlers
- Gleichzeitiger Betrieb mehrerer Feuchtefühler, die wiederum unterschiedliche Meßbereiche haben können.

Das Meßverfahren und die Meßschaltung gemäß der Erfindung sind nachstehend anhand eines in den Zeichnungen dargestellten Ausführungsbeispiels näher erläutert:
Es zeigen:

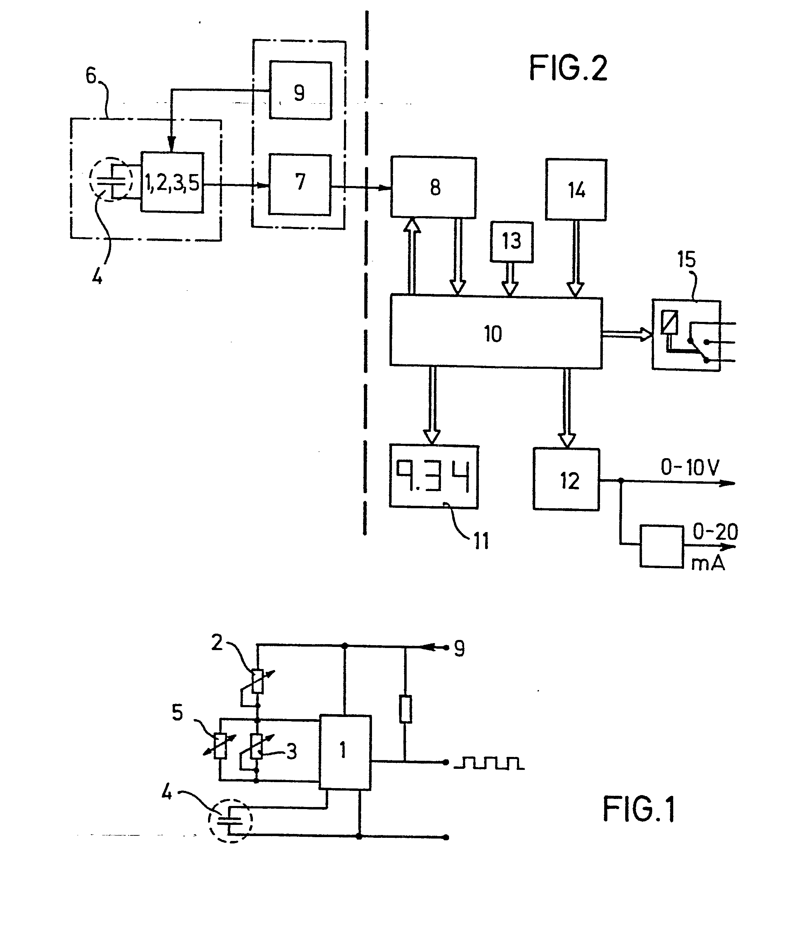

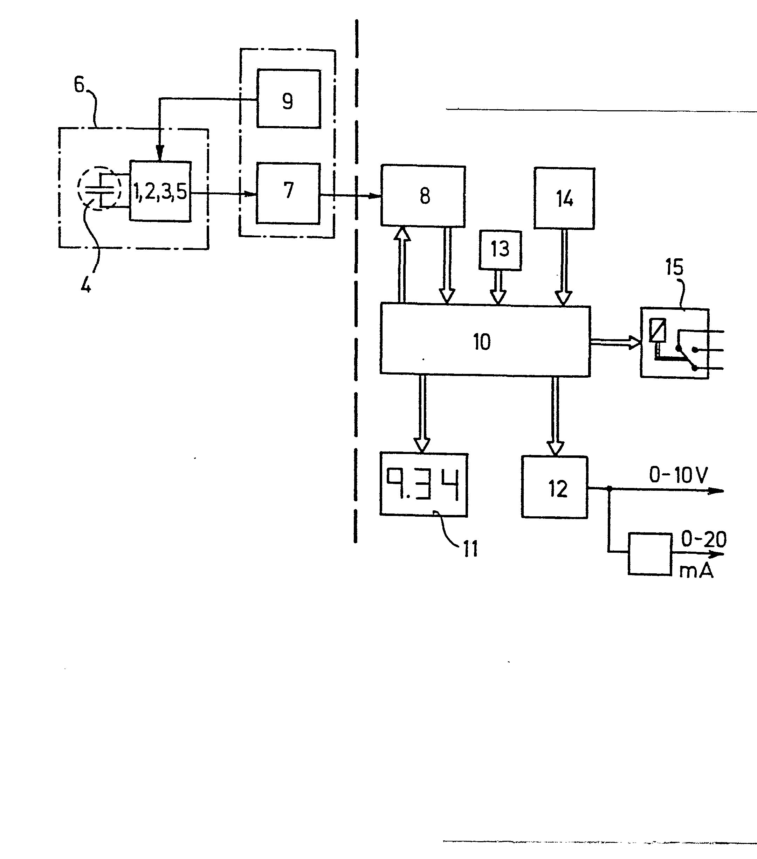

Figur 1: Schaltschema für die Erzeugung einer zur Feuchte proportionalen Frequenz

Figur 2: Blockschaltplan für die Auswertung und Verarbeitung der Meßsignalfrequenz

Der Oszillator besteht aus einem Zeitgeber 1, der als integrierter Schaltkreis (Timer-Baustein) im Fachhandel erhältlich ist und mit einem Widerstand ($R_A$) 2 und einem

0019154

Widerstand ($R_B$) 3 so beschaltet wird, daß er mit einem kapazitiven Feuchtefühler 4 einen astabilen Multivibrator bildet, dessen Frequenz durch die Gleichung

$$f = const. \cdot 1/((R_A + 2R_B)C)$$ bestimmt ist. Die Widerstände 2 und 3 sind als Potentiometer ausgebildet, um die Grundfrequenz des Oszillators der Feuchtefühlerkapazität 4 anpassen zu können. Hierdurch erhält man einen großen dynamischen Meßbereich bei gleichbleibend vorgegebener Genauigkeit. Mit einem NTC-Widerstand 5 (Widerstand mit negativem Temperaturkoeffizient), der dem Widerstand 3 parallel geschaltet ist, wird der Temperaturgang des Feuchtefühlers 4 und des Zeitgebers 1 kompensiert. Die Größe des NTC-Widerstandes 5 muß dem Typ des Feuchtefühlers 4 angepaßt werden.

Ein Fühlergehäuse 6, das direkt am Meßort installiert werden kann, nimmt den Feuchtefühler 4 einschließlich der feuchteproportionalen Frequenzerzeugung 1, 2, 3, 5, auf.

Der Ausgang des Zeitgebers 1 ist mit dem Auswerte- und Verarbeitungsteil der Meßschaltung verbunden, dem eine Anzeigeeinrichtung nachgeschaltet ist. Der Auswerte- und Verarbeitungsteil ist aus einem Zähler 8 und einem Mikroprozessor 10 aufgebaut, wobei der Zähler vom Mikroprozessor in seiner Öffnungszeit für die Erfassung der Oszillatorfrequenz in einem bestimmten Zeitintervall gesteuert wird. Das Zeitintervall wird entsprechend dem Meßwert und der geforderten Auflösung gewählt.

Es versteht sich, daß anstelle des Mikroprozessors je nach Meßaufgabe, Meßbereich und Genauigkeit auch andere bekannte digitale Steuereinrichtungen und ggf. Rechenwerke verwendet werden können. Ebenso kann auf den Zähler verzichtet werden, wenn die Meßsignalfrequenz vom Mikroprozessor direkt verarbeitet werden kann.

Entsprechend der Programmierung übernimmt der Mikroprozessor 10 den den Feuchtemeßwert darstellenden Zählerstand, formt ihn in einen linearen Meßwert um, der einer Digitalanzeige 11 zugeführt und für einen Schreiberausgang über einen Digital/Analog-Wandler 12 in eine Spannungs- bzw. Stromgröße umgewandelt wird. Dabei prüft der Mikroprozessor, welchem Meßbereich das Meßsignal zuzuordnen ist. Hieraus können dann verschiedene Steuerbefehle folgen, beispielsweise die Ansteuerung eines potentialfreien Relais 15, wenn ein Grenzwert überschritten wird oder die Signalisierung von Grenzwerten, z.B. mit Hilfe von Warnlampen.

Die linearisierten Meßwerte ermittelt der Mikroprozessor mit Hilfe eines Polynoms dritten Grades, durch das die Eichkurven nach der Methode der kleinsten Fehlerquadrate angenähert sind. Diese Annäherung wird nach einer Grundeichung extern mit einem Rechner durchgeführt. Die Grundeichdaten werden in einem batteriegepufferten Speicher 13 gespeichert und stehen dem Mikroprozessor dadurch auch nach einem Netzausfall sofort wieder zur Verfügung. Über ein Bedientastenfeld 14 lassen sich neue Grundeichdaten eingeben oder Statussignale abfragen, die über den Zustand des Meßsystems eine Aussage geben.

Bei Meßorten in explosionsgefährdeten Zonen und einer Meßsignalverarbeitung in gefahrfreien Zonen ist eine galvanische Trennung zwischen dem Feuchtefühler 4 mit dem Oszillator 1 und dem Auswerte- und Verarbeitungsteil 8, 10 mit der Digitalanzeige 11 der Meßschaltung erforderlich. Für diese Entkoppelung eignet sich besonders ein Optokoppler 7, der dann zwischen den Oszillatorausgang und den Zählereingang zu schalten ist. Selbst-

0019154

verständlich können auch andere geeignete Entkoppelungsmittel, beispielsweise Kondensatoren, verwendet werden.
Der Oszillator wird dann mit Hilfe einer eigensicheren
Einspeisung 9 versorgt.

Patentansprüche

1. Meßverfahren zur kontinuierlichen meßtechnischen Erfassung von Feuchte mittels eines kapazitiven Feuchtefühlers, bei dem die Frequenz eines Oszillators durch die Kapazität des Feuchtefühlers beeinflußt wird und die beeinflußte Frequenz als Meßsignal in einer Auswerteschaltung verarbeitet und danach zur Anzeige gebracht wird, dadurch gekennzeichnet, daß die durch den Feuchtefühler beeinflußte Frequenz durch Zählen der Schwingungen des Oszillatorsignals in einem vorgegebenen Zeitintervall direkt digital ausgewertet und das Zählergebnis direkt oder nach Umrechnung in die Feuchteeinheit angezeigt wird.

2. Meßverfahren nach Anspruch 1, dadurch gekennzeichnet, daß die Frequenz des Oszillators in einem Mikroprozessor ausgewertet und in die anzuzeigende Feuchteeinheit umgerechnet wird.

3. Meßverfahren nach Anspruch 1, dadurch gekennzeichnet, daß die Frequenz des Oszillators mit Hilfe eines Zählers in aufeinanderfolgenden Zeitintervallen erfaßt und der Zählerstand der Zeitintervalle direkt oder nach Umrechnung in die Feuchteeinheit jeweils zur Anzeige gebracht werden.

4. Meßverfahren nach Anspruch 3, dadurch gekennzeichnet, daß die Zählerstände von einem Mikroprozessor abgefragt und von diesem für die Feuchteanzeige verarbeitet werden.

5. Meßverfahren nach Anspruch 1 bis 4, dadurch rekennzeichnet, daß die von der zu messenden Feuchte abhängige Frequenz am Ort des kapazitiven Feuchtefühlers erzeugt wird.

6. Meßschaltung zur Durchführung des Meßverfahrens nach
den Ansprüchen 1 bis 5 mit einem kapazitiven Feuchtefühler, der als Kapazität eines Oszillators geschaltet ist, dadurch gekennzeichnet, daß der Ausgang des
Oszillators (1) über eine digitale Auswerteschaltung
mit einer Anzeigeeinrichtung (11) in Verbindung
steht.

7. Meßschaltung nach Anspruch 6, dadurch gekennzeichnet,
daß der Oszillator (1) von der Auswerteschaltung
galvanisch entkoppelt ist.

8. Meßschaltung nach Anspruch 7, dadurch gekennzeichnet,
daß der Oszillator (1) über einen Optokoppler (7)
mit der Auswerteschaltung verbunden ist.

9. Meßschaltung nach Anspruch 6 bis 8, dadurch gekennzeichnet, daß die Auswerteschaltung aus einem digitalen Zähler (8) besteht, der zum Schalten der
Zählintervalle von einem Taktgenerator steuerbar
ist und dessen Ausgang direkt oder über ein digitales Rechenwerk mit der Anzeigeeinrichtung (11)
verbunden ist.

10. Meßschaltung nach Anspruch 9, dadurch gekennzeichnet, daß das digitale Rechenwerk ein Mikroprozessor (10) ist.

Zeichn.

BAD ORIGINAL

# FIG.2

**9.34**

0-10 V

0-20 mA

# FIG.1

Nummer der Anmeldung

EP 80102371.4

Europäisches
Patentamt

**EUROPÄISCHER RECHERCHENBERICHT**

| | EINSCHLÄGIGE DOKUMENTE | | KLASSIFIKATION DER ANMELDUNG (Int Cl 3) |
|---|---|---|---|
| Kategorie | Kennzeichnung des Dokuments mit Angabe, soweit erforderlich, der maßgeblichen Teile | betrifft Anspruch | G 01 N 27/22 |
| | AT - B - 321 003 (KINGSBURY) <br> + Fig. 1,3; Seite 5, Patent- <br> ansprüche + <br> -- | 1,3,6, 9 | |
| A | DE - B - 1 598 456 (KINGSBURY) <br> + Fig. 3,4 + <br> -- | | |
| | GB - A - 1 416 640 (DICKEY-JOHN) <br> + Fig. 1,6 + <br> -- | 1,5,6, 9 | |
| A | O. LIMANN "Elektronik ohne Bal- <br> last", 4. Auflage, 1975 <br> FRANZIS-VERLAG GMBH, München <br> + Seite 304, Bild 22.11 d); <br> Seite 305, linke Spalte, 3. <br> Absatz + <br> -- | 1,3,6, 9 | **RECHERCHIERTE SACHGEBIETE (Int. Cl 3)** <br><br> G 01 N 27/00 <br> G 01 R 27/00 |
| A | W. SCHMIDT, O. FEUSTEL "Opto- <br> elektronik kurz und bündig", 1975, <br> VOGEL-VERLAG, Würzburg <br> + Seiten 163-165 + <br> -- | 7,8 | |
| X | US - A - 3 761 810 (BURROWS....) <br> + Fig. 1,3 + <br> -- | 1,3,5, 6,9 | **KATEGORIE DER GENANNTEN DOKUMENTE** <br><br> X: von besonderer Bedeutung <br> A: technologischer Hintergrund <br> O: nichtschriftliche Offenbarung <br> P: Zwischenliteratur <br> T: der Erfindung zugrunde <br> liegende Theorien oder <br> Grundsätze <br> E: kollidierende Anmeldung <br> D: in der Anmeldung angeführtes <br> Dokument <br> L: aus andern Gründen <br> angeführtes Dokument |
| X | CH - A - 567 268 (COMMISSARIAT...) <br> + Fig. 2; Spalte 4, Zeilen 60, <br> 61 + <br> -- | 1,3,6, 9 | |
| | US - A - 4 064 455 (HOPKINS) <br> + Fig. 1; Spalte 5, Zeilen 38- <br> 40 + <br> -- | 2,10 | |
| X | Der vorliegende Recherchenbericht wurde für alle Patentansprüche erstellt. | | &. Mitglied der gleichen Patent- <br> familie, übereinstimmendes <br> Dokument |
| Recherchenort <br> WIEN | Abschlußdatum der Recherche <br> 14-07-1980 | | Prüfer <br> BURGHARDT |

EPA form 1503.1   06.78

Europäisches
Patentamt

Nummer der Anmeldung

EP 80102371.4

**EUROPÄISCHER RECHERCHENBERICHT**

| Kategorie | Kennzeichnung des Dokuments mit Angabe, soweit erforderlich, der maßgeblichen Teile | betrifft Anspruch |
|---|---|---|
| | US - A - 3 979 581 (HAUNI-WERKE)<br>+ Fig. 2 +<br>---- | 2,10 |

## EINSCHLÄGIGE DOKUMENTE

KLASSIFIKATION DER ANMELDUNG (Int Cl.X) 3

RECHERCHIERTE SACHGEBIETE (Int. Cl.3) X 3

EPA Form 1503.2   06.78